(19) **Europäisches Patentamt**
**European Patent Office**
**Office européen des brevets**

(11) **EP 3 499 823 B1**

(12) **EUROPEAN PATENT SPECIFICATION**

(45) Date of publication and mention of the grant of the patent:
**16.09.2020  Bulletin 2020/38**

(21) Application number: **17208188.7**

(22) Date of filing: **18.12.2017**

(51) Int Cl.:
*H04L 25/03* (2006.01)          *H04L 27/01* (2006.01)
*H03M 13/00* (2006.01)          *H03M 13/11* (2006.01)
*H03M 13/29* (2006.01)

(54) **METHOD AND DEVICE FOR DEMODULATING RECEIVED SYMBOLS USING A TURBO EQUALIZATION LOOP FOR A SINGLE CARRIER SYSTEM**

VERFAHREN UND VORRICHTUNG ZUR DEMODULATION VON EMPFANGENEN SYMBOLEN MIT EINER TURBO-ENTZERRUNGSSCHLEIFE FÜR EIN EINZELTRÄGERSYSTEM

PROCÉDÉ ET DISPOSITIF POUR DÉMODULER DES SYMBOLES REÇUS À L'AIDE D'UNE BOUCLE D'ÉGALISATION TURBO POUR UN SYSTÈME À PORTEUSE UNIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**19.06.2019  Bulletin 2019/25**

(73) Proprietors:
• **Mitsubishi Electric R & D Centre Europe B.V.**
**1119 NS Schiphol Rijk (NL)**
• **Mitsubishi Electric Corporation**
**Tokyo 100-8310 (JP)**

(72) Inventor: **CASTELAIN, Damien**
**35708 RENNES Cedex 7 (FR)**

(74) Representative: **Cabinet Le Guen Maillet**
**3, impasse de la Vigie**
**CS 71840**
**35418 Saint-Malo Cedex (FR)**

(56) References cited:
**EP-A1- 3 151 434     US-A1- 2013 336 377**

• **AMPELIOTIS D ET AL: "Turbo Equalization of Non-Linear Satellite Channels Using Soft Interference Cancellation", ADVANCED SATELLITE MOBILE SYSTEMS, 2008. ASMS '08. 4TH, IEEE, PISCATAWAY, NJ, USA, 26 August 2008 (2008-08-26), pages 289-292, XP031317943, ISBN: 978-1-4244-2159-6**
• **BENAMMAR BOUCHRA ET AL: "A comparison of iterative receivers for the non linear satellite channel", 2015 IEEE 16TH INTERNATIONAL WORKSHOP ON SIGNAL PROCESSING ADVANCES IN WIRELESS COMMUNICATIONS (SPAWC), IEEE, 28 June 2015 (2015-06-28), pages 520-524, XP033213291, DOI: 10.1109/SPAWC.2015.7227092 [retrieved on 2015-08-27]**

EP 3 499 823 B1

**Description**

TECHNICAL FIELD

The invention concerns a method for demodulating received symbols using a turbo-equalization performed in the frequency domain and Volterra series used for correcting the non-linear part of interference in the time domain.

RELATED ART

The use of Volterra series to model the non-linearity of a satellite simulation chain was first presented in the paper of S. Benedetto, E. Biglieri and R. Daffara, entitled "Modeling and Performance Evaluation of Nonlinear Satellite Links - A Volterra Series Approach", published in IEEE AES-15, NO. 4, July 1979.

Volterra series provide an input-output relationship for nonlinear channels with memory satisfying certain regularly conditions. Volterra series are rather general. However, in this paper a form of Volterra series which is suitable to represent satellite channels is proposed, where the complex envelopes of input and output signals appear and where Volterra series can take the form:

$$y_n = \sum_{n_1=0}^{M-1} h_{n_1} x_{n-n_1} + \sum_{n_1=0}^{M-1}\sum_{n_1=0}^{M-1}\sum_{n_2=0}^{M-1} h_{n_1 n_2 n_3} x_{n-n_1} x_{n-n_2} \overline{x}_{n-n_3} + \ldots$$

$$+ \sum_{n_1=0}^{M-1}\sum_{n_1=0}^{M-1}\ldots\sum_{n_{k-1}=0}^{M-1} h_{n_1 \ldots n_{k-1}} x_{n-n_1} x_{n-n_2} \ldots \overline{x}_{n-n_{k-1}}$$

where $M$ is the memory of the filter, $k$ is the order, and $\overline{x}$ stands for the conjugate of $x$. Note that for a $k$-order term, $k$ is always odd in this context, $(k-1)/2$ "$x$" values are conjugate. The $h_{n_1 \ldots n_{k-1}}$ are the coefficients of the Volterra series.

In the paper of B. F. Beidas, R. I. Seshadri, M. Eroz and L. Lee entitled "Faster-than-Nyquist Signaling and Optimized Signal Constellation for High Spectral Efficiency Communications in nonlinear Satellite Systems", published in IEEE MILCOM, 2014, the Volterra series was used in a turbo-equalization chain of a Faster-Than-Nyquist (FtN) signal.

In this situation, the correction is indirect. The Volterra series model the global chain, including the FtN filter, model which is used to generate an estimation of the interference from likelihood information provided by the channel decoder. This interference is then subtracted from the demodulated signal at the output of a simple demodulator before equalization. It is worth noting that this interference corresponds to both the non-linearity induced by the power amplifier and the linear interference brought by a process like FtN. Beidas uses Volterra series for correcting both the linear part and the non-linear part of the interference in the time domain. FtN produces a large amount of interference, with a large time span that generates two consequences.

A first one is that correcting such a large interference by simply subtracting an estimation of the interference is not generally optimal, as the linear interference contains useful information by itself.

A second one is that the complexity of the time domain correcting filter can be very large. This can be particularly important if FtN is combined with SC-OFDM, or SC-FDMA or DFT-spread OFDM, which allows an efficient 0% roll-off.

As the linear part of the interference can be time-varying, because of mobility or phase noise, the Volterra coefficients calculation must follow these variations, which can complicate the process a lot. On the opposite, the non-linear effect induced by the power amplifier and the transmission filters varies very slowly.

EP3151434 A1 is related to a turbo equalizer for single carrier systems for cancelling linear channel effects.

US2013/336377 A1 is related to turbo equalization based on Volterra modelling to cancel both linear and non-linear interferences.

SUMMARY OF THE INVENTION

The present invention aims at reducing the complexity of the use of Volterra series.

The present invention concerns a method for demodulating received symbols using a turbo equalization loop for a single carrier system, characterized in that the method comprises the steps of:

- performing a discrete Fourier transform on the received symbols,
- equalizing in the frequency domain the discrete Fourier transformed received symbols in order to obtain equalized symbols,
- executing an inverse discrete Fourier transform on the equalized symbols in order to obtain equalized symbols in the time domain,
- executing a first subtracting step by subtracting, from equalized symbols in the time domain, non-linear interference,
- de-mapping the output of the first subtracting step,
- decoding the output of the de-mapping step,
- executing a second subtracting step by subtracting, from the output of decoding step, the input of the decoding step,

and the output of second subtracting step is provided to the equalization step, to the non-linear interference generation step, the non-linear interference being obtained by a Volterra series, the coefficients of which being determined from the equalized symbols in the time domain.

The present invention concerns also a device for demodulating received symbols using a turbo equalization loop for a single carrier system, characterized in that the device comprises:

- means for performing a discrete Fourier transform on the received symbols,
- means for equalizing in the frequency domain the discrete Fourier transformed received symbols in order to obtain equalized symbols,
- means for executing an inverse discrete Fourier transform on the equalized symbols in order to obtain equalized symbols in the time domain,
- means for executing a first subtracting step by subtracting, from equalized symbols in the time domain, non-linear interference,
- means for de-mapping the output of the first subtracting step,
- means for decoding the output of the de-mapping step,
- means for executing a second subtracting step by subtracting, from the output of decoding step, the input of the decoding step,

and the output of second subtracting step is provided to the equalization step, to the non-linear interference generation step, the non-linear interference being obtained by a Volterra series, the coefficients of which are determined from the equalized symbols in the time domain.

Thus, as the linear part of the interference is treated in the frequency domain, the Volterra series only models the non-linear part of the interference. Thus the series is shorter than if the linear part was still present. Moreover, the non-linear part varies much slowly than the linear part and the update of the coefficients is easier. Thus globally, the complexity is reduced.

According to a particular feature, Volterra coefficients determination is further determined from the output of second subtracting step or from fixed known transmitted symbols.

Thus, the interference is reduced and performances are improved, with a low complexity correction scheme.

According to a particular feature, non-linear interference is derived from:

$$E\left(I_n\right) = \sum_{i=1}^{N-1} a_i\, E\left(\phi_i\left(\underline{x}_n\right)\right)$$

where $\underline{x}_n$ is a vector containing $x_n$ and its neighbours, $N$ is the number of terms, $\phi_i(.)$ are the Volterra terms, $a_i$ are the coefficients, $I_n$ is the interference and $E$ is the probabilistic mean, estimated from the extrinsic information provided by the channel decoder.

Thus, the non-linear interference is carefully estimated, which allows to improve performances by removing this non-linear interference estimation from the received signal.

According to a particular feature, the coefficients $a_i$ are determined from $a = R^{-1}z$, where $R$ is an autocorrelation matrix $R$ defined as :

$$R_{ij} = E\left(\phi_i\, \overline{\phi_j}\right)$$

and $z$ is a correlation vector between the linearly equalized symbols $y_n$ and the kernels $\phi_i$ associated to the input $x$ is defined as:

$$z_i = E\left( y\,\overline{\phi}_i \right)$$

and wherein for each value of $z_i$ that is lower than a predetermined threshold value, the corresponding coefficient $a_i$ is not calculated, $y_n$ are the realizations at time n of the probabilistic variable y, and correspond to the equalized symbols in the time domain.

Thus, the sizes of matrix $R$ and vector $a$ are reduced, and thus complexity is reduced.

According to a particular feature, the coefficients may be determined by memorizing a given amount of known $x_n$ and linearly equalized symbols $y_n$.

According to a particular feature, the method is executed by a receiver that comprises memory means that memorize one inverse of the autocorrelation matrix for each constellation that may be used for transferring the received symbols.

Thus, this matrix does not need to be calculated and the complexity is reduced.

The present invention concerns also a computer program comprising program code instructions which can be loaded in a programmable device for implementing the method according to the first embodiment, when the program code instructions are run by the programmable device.

The present invention also concerns information storage means storing a computer program comprising program code instructions which can be loaded in a programmable device for implementing the method according to the first embodiment, when the program code instructions are run by the programmable device.

BRIEF DESCRIPTION OF THE DRAWINGS

The characteristics of the present invention mentioned above, as well as other characteristics will appear more clearly on reading the following description of an example of an embodiment, said description being done in relation with the joint drawings, among which:

- Fig. 1 illustrates schematically an example of a communication system in which the invention may be implemented;
- Fig. 2 illustrates schematically an example of a receiver in which the present invention may be implemented;
- Fig. 3 represents an example of a hardware architecture of a wireless interface of the receiver in which the present invention may be implemented;
- Fig. 4 represents an example of an algorithm executed by the wireless interface of the receiver according to the present invention.

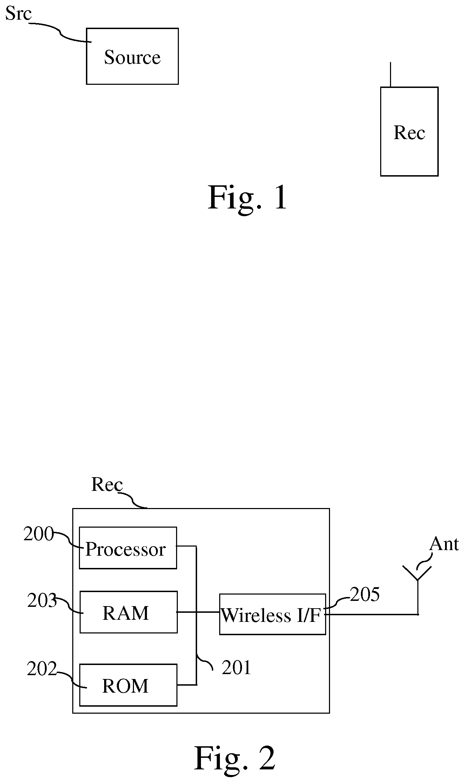

**Fig. 1** illustrates schematically an example of a telecommunication system in which the invention can be implemented.

The telecommunication system comprises at least a source Src which transmits symbols to at least one receiver Rec.

The telecommunication system may be a 3GPP/LTE uplink wireless telecommunication system using for example Single-Carrier Frequency Division Multiple Access (SC-FDMA) or a broadcasting telecommunication network like a DVB (Digital Video Broadcast) Next Generation broadcasting system to Handheld (NGH) telecommunication system using for example single-carrier orthogonal frequency division multiplex (SC-OFDM) for its satellite component or may be any communication network with a single-carrier type modulation.

SC-FDMA is a modulation scheme with OFDM-type multiplexing but single-carrier-like envelope. It can be implemented either in the time-domain (IFDMA) or in the frequency-domain. In the last case, it is also called DFT-spread OFDM, or SC-FDE (Single Carrier Frequency domain Equalisation) or SC-OFDM (Single Carrier Frequency Division Multiple Access).

According to a particular feature, the telecommunication system, for improving spectral efficiency, uses a non-orthogonal transmission scheme Faster-Than-Nyquist (FtN).

Inter-symbol interference (ISI) is a distortion that occurs to the sent symbols when they overlap partially or totally leading to a degraded detection performance at the receiver. Equalization is needed to cancel or limit performance degradation due to ISI. Turbo-equalization, i.e. feedback from the channel decoder to the equalization process, improves equalization performance when a channel decoder is used.

According to the present invention, the receiver Rec:

- performs a discrete Fourier transform on the received symbols,
- equalizes in the frequency domain the discrete Fourier transformed received symbols in order to obtain equalized symbols,

- executes an inverse discrete Fourier transform on the equalized symbols in order to obtain equalized symbols in the time domain,
- executes a first subtracting step by subtracting, from equalized symbols in the time domain, non-linear interference,
- de-maps the output of the first subtracting step,
- decodes the output of the de-mapping step,
- executes a second subtracting step by subtracting, from the output of decoding step, the input of the decoding step,

and the output of second subtracting step is provided to the equalization, to the non-linear interference generation, optionally to the de-mapping, the non-linear interference being obtained by a Volterra series, the coefficients of which are determined from the equalized symbols in the time domain.

**Fig. 2** illustrates schematically an example of a receiver in which the present invention may be implemented.

According to the shown architecture, the receiver Rec comprises the following components interconnected by a communication bus 201: a processor, microprocessor, microcontroller or CPU (*Central Processing Unit*) 200; a RAM (*Random-Access Memory*) 203; a ROM (*Read-Only Memory*) 202 and a wireless interface 205 connected to at least one antenna.

The wireless interface 205 allows the receiver Rec to receive symbols.

CPU 200 is capable of executing instructions loaded into RAM 203 from ROM 202 or from an external memory. After the receiver Rec is powered on, CPU 200 is capable of reading instructions from RAM 203 and executing these instructions. The instructions form one computer program that causes CPU 200 to decode received symbols according to the present invention.

The decoding may be implemented in software by execution of a set of instructions or program by a programmable computing machine, such as a PC (*Personal Computer*), a DSP (*Digital Signal Processor*) or a microcontroller; or else implemented in hardware by a machine or a dedicated component, such as an FPGA (*Field-Programmable Gate Array*) or an ASIC (*Application-Specific Integrated Circuit*).

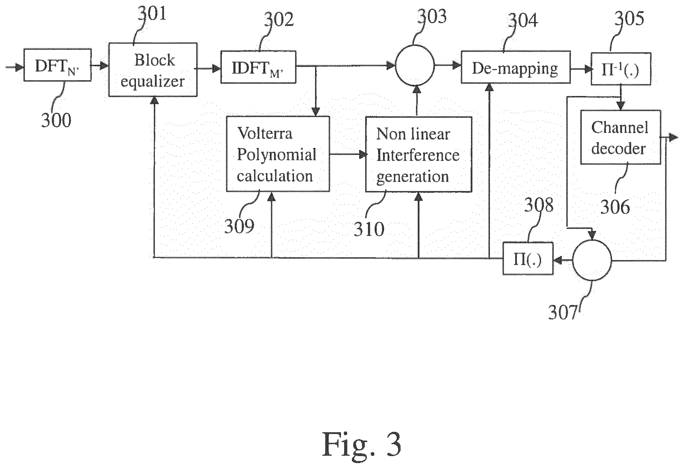

**Fig. 3** represents an example of a hardware architecture of a wireless interface of the receiver in which the present invention may be implemented.

The example of hardware architecture given in Fig. 3 is in a Single Carrier system. As already stated, the present invention found applications in other contexts.

The wireless interface 205 comprises a discrete Fourier transform (DFT) module 300, a block equalizer 301, an inverse discrete Fourier transform (IDFT) module 302, a subtracting module 303, a de-mapping module 304, a channel decoder 306, a subtracting module 307, a Volterra polynomial calculation module 309 and a non-linear interference generation module 310 and may comprise a de-interleaving module 305 and an interleaving module 308. As an example, the block equalizer 301 is a MMSE (Minimum Mean Square Error) equalizer. Here, a block processed by the block equalizer 301 corresponds to a set of samples over which DFT and IDFT are processed.

The DFT module 300 provides samples to the block equalization module 301.

The block equalizer module 301 performs an equalization.

The output of the block equalizer 301 is provided to the IDFT module 302 which performs an inverse discrete Fourier transform of size M'. M' is lower than N', the size of the discrete Fourier transform performed by the DFT module 300. The output of the IDFT module 302 is provided to the subtracting module 303 and to the Volterra polynomial calculation module 309.

The output of the subtracting module 303 is provided to the de-mapping module 304.

The de-mapping module 304 may perform a turbo de-mapping based on the output of the subtracting module 303 and based on the output of the interleaving module 308 or based on the output of subtracting module 307 if no interleaving is performed.

The output of the de-mapping module 304 consists in soft estimations like LLR and is provided to a de-interleaving module 305 if there is, which de-interleaves the soft estimations or to the channel decoder 306.

The de-interleaving module 305 may de-interleave the soft estimations code block by code block or may de-interleave the soft estimations by set of code blocks if interleaving is performed on a set of code blocks.

A code block corresponds to a codeword.

The output of the de-interleaving module 305 if there is, is provided to the iterative channel decoder 306.

The channel decoder 306 is for example a LDPC (Low Density Parity Check) decoder or a CTC (Convolutional Turbo Code) decoder or a BTC (Block Turbo Code) decoder or a polar code decoder.

The output of the channel decoder 306 is outputted as the decoded symbols and provided to the subtracting module 307.

The subtracting module 307 subtracts the output of the de-interleaving module if there is one to the output of the channel decoder 306 or subtracts the output of the de-mapping module 304 to the output of the channel decoder 306.

The output of the subtracting module 308 so-called extrinsic information is provided to the interleaving module 308 if there is, which performs a reverse process as the one performed by the de-interleaving module 305. The output of the interleaving module 307 if there is provided to the de-mapping module 304, to the block equalizer 301, to the Volterra polynomial calculation module 309 and to the non-linear interference generation module 310.

If the interleaving module 308 is not there, the output of the subtracting module 307, so-called extrinsic information, is provided to the block equalizer 301, to the Volterra polynomial calculation module 309, to the de-mapping module 306, and to the non-linear interference generation module 310.

The output of the Volterra polynomial calculation module 309 is provided to the non-linear interference generation module 310.

The output of the non-linear interference generation module 310 is provided to the subtracting module 303.

The subtracting module 303 subtracts the output of non-linear interference generation module 310 to the output of the IDFT module 302.

A soft estimation $x$ of the transmitted data is obtained from the log-likelihood information provided by the channel decoder 306, this information having passed through the optional interleaving module 308. The estimate interference $I_{n-d}$ is obtained by the non-linear interference generation module 310 from the Volterra series by ignoring the term corresponding to the data to be estimated:

$$I_{n-d} = \sum_{n_1=0}^{M-1} h_{n_1} x_{n-n_1} + \sum_{n_1=0}^{M-1}\sum_{n_1=0}^{M-1}\sum_{n_2=0}^{M-1} h_{n_1 n_2 n_3} x_{n-n_1} x_{n-n_2} \overline{x}_{n-n_3} + \ldots$$

$$+ \sum_{n_1=0}^{M-1}\sum_{n_1=0}^{M-1}\ldots\sum_{n_{k-1}=0}^{M-1} h_{n_1 \ldots n_{k-1}} x_{n-n_1} x_{n-n_2} \ldots \overline{x}_{n-n_{k-1}} - h_d x_{n-d}$$

Here, $d$ is the delay associated with the Volterra series, generally $d = \dfrac{M-1}{2}$, $M$ is the memory size of the Volterra series and the subtracted term $h_d x_{n-d}$ corresponds to the information to be estimated.

In order to simplify the analysis, the Volterra polynomial is represented as:

$$y_n = \sum_{i=0}^{N-1} a_i \phi_i\left(\underline{x}_n\right)$$

where $\underline{x}_n$ is a vector containing $x_n$ and its neighbours, $N$ is the number of terms, $\phi_i(.)$ are the Volterra terms (or kernels), $a_i$ are the coefficients

$$\underline{x}_n = \left(x_{n-f}, x_{n-f+1}, \ldots, x_{n+b}\right)^T$$

with $b+f+1 = M$, the memory of the Volterra series.

The $a_i$ terms correspond to a renaming of the $h_{n_1 \cdots n_{k-1}}$, after reordering of these coefficients.

Without any loss in generality, we will assume that the first term is the central one, corresponding to $x_n$ :

$$\phi_0\left(\underline{x}_n\right) = x_n$$

With these notations, the interference is expressed as

$$I_n = P\left(\underline{x}_n\right) - a_0 x_n = \sum_{i=1}^{N-1} a_i \phi_i\left(\underline{x}_n\right)$$

It must be noted that as the Volterra series is only a model of the global chain, this interference term is only an estimation of the real interference.

Moreover, in the turbo loop represented in Fig. 3, the values $x_n$ are not perfectly known. The turbo-decoder provides the so-called extrinsic information, which after passing through the (optional) interleaving module 308, acts as a priori information for the block equalizer 301, the non-linear interference generation module 310 and the de-mapping module 304. In practice, this *a priori* information consists in log-likelihood ratio (the LLR). From these LLR, it is straightforward to derive the probabilities associated with each constellation point and each transmitted symbol, and then to derive the mean of each Volterra term $E(\phi_i(\underline{x}_n))$.

Finally, the used interference estimation is obtained as:

$$E\left(I_n\right) = \sum_{i=1}^{N-1} a_i \, E\left(\phi_i\left(\underline{x}_n\right)\right)$$

The Volterra polynomial calculation module 309 determines the Volterra coefficients $a_i$.

The Volterra coefficients $a_i$ are calculated from known sequences $x_n$ and the linearly equalized symbols $y_n$ provided by the output of the IDFT module 302.

Concerning the known sequences, they can be either fixed sequences sent regularly, for example for synchronization or channel estimation, or sequences that have been decoded correctly by the channel decoder 306.

The coefficients are calculated so as to minimize the mean of the square error:

$$\min_{a_i} E\left(\left\| y_n - \sum_{i=0}^{N-1} a_i \, \phi_i\left(\underline{x}_n\right) \right\|^2\right)$$

Let us define the vectors $a = (a_0,...,a_{N-1})^T$, $X_n = (\phi_0(\underline{x}_n),...,\phi_{N-1}(\underline{x}_n))^T$, above mentioned equation can be rewritten as:

$$\min_{a} E\left(\left\| y_n - a^T X_n \right\|^2\right)$$

This is a particular case of polynomial regression applied to Volterra series. The solution is provided by:

$$a = R^{-1}z$$

where the autocorrelation matrix $R$ is defined as:

$$R_{ij} = E\left(\phi_i \, \overline{\phi}_j\right)$$

and the correlation vector $z$ between the observation $y$ and the kernels $\phi_i$ associated to the input $x$ is defined as:

$$z_i = E\left(y \, \overline{\phi}_i\right)$$

The coefficients may be determined by memorizing a given amount of known sequences $x_n$ and linearly equalized symbols $y_n$, evaluating $R$ and $z$ from these known sequences $x_n$ and linearly equalized symbols $y_n$ and then resolve equation $a = R^{-1}z$.

According to the invention each value $z_i$ is compared to a threshold value, that is for example equal to $3.0 \, 10^{-3}$, for an average value of the amplitude of $x$ equal to 1. The optimal value depends on the scenario, for example depends of the robustness of the modulation and coding scheme.

For each value of $z_i$ that is lower than the threshold value, the corresponding coefficient $a_i$ is not calculated,

which reduces the sizes of R and vector a, and thus reduces the complexity of the Volterra series calculation.

In the proposed scheme, the linear equalization is performed before the Volterra correction. Therefore, the correction only depends on the power amplifier and the transmit/receive filters, which change very slowly or not at all.

Several solutions exist for the resolution of the linear system $a = R^{-1}z$.

The simplest adaptive algorithm is LMS (Least Mean Square). Let us call $a_n$ the estimation vector a at instant n (the corresponding observation $X_n$ is defined above). Then, the coefficient vector is updated by:

$$a_{n+1} = a_n + \mu X_n e_n = a_n + \mu X_n \left( y_n - a_n^T X_n \right)$$

where $e_n$ is the instantaneous error and where $\mu$ is the gain constant that regulates the speed and stability of adaptation.

For example, error $e_n$ is averaged on K several successive received samples before applying $a_{n+K} = a_n + \mu X_n$ average ($e_n$).

In this case, the coefficients are updated every K samples, and a larger gain $\mu$ can be used.

The LMS method has the advantage not to rely on knowledge or estimation of R matrix.

When R matrix is known, the LMS/Newton method may be used. As R matrix depends only of used constellation, the receiver may memorize the inverse matrix $R^{-1}$ that corresponds to the used constellation. The coefficient vector is now updated by:

$$a_{n+1} = a_n + \mu R^{-1} X_n e_n = a_n + \mu R^{-1} X_n \left( y_n - a_n^T X_n \right)$$

It has to be noted here that error $e_n$ may be averaged on K several successive received samples as previously disclosed in the LMS case:

$$a_{n+K} = a_n + \mu R^{-1} \bar{X}_n \, average\left( e_n \right)$$

This LMS/Newton method is known to converge more rapidly than the LMS method and is less complex than the RLS (Recursive Least Square) method.

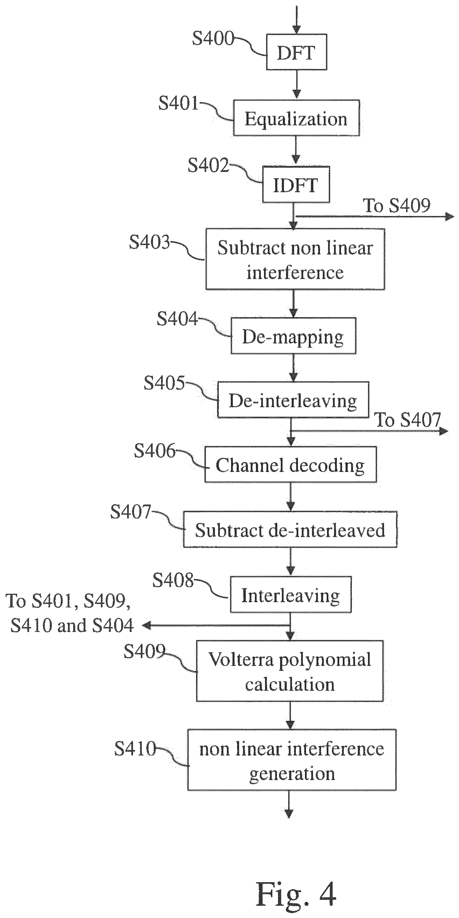

**Fig. 4** represents an example of an algorithm executed by the wireless interface of the receiver according to the present invention.

At step S400, a DFT is performed on the received symbols in order to provide samples.

At step S401, a block equalization is performed on the samples.

At step S402, an inverse discrete Fourier transform is performed on the output of the block equalizer step S401. The inverse discrete Fourier transform has a size of M'. M' is lower than N', the size of the discrete Fourier transform performed at step S400.

The output of the IDFT step S402 is provided to a subtracting step S403 and to a Volterra polynomial calculation step S409.

The subtracting step S403 subtracts the output of the non-linear interference generation step S410 to the output of the IDFT step S402.

The output of the subtracting step S403 is provided to a de-mapping step S404 that may perform a turbo de-mapping based on the output of the subtracting step S403 and based on the output of an interleaving step S408 or based on the output of a subtracting step S407 if no interleaving is performed.

The output of the de-mapping step S404 consists in soft estimations like LLR and is provided to a de-interleaving step S405 if there is, which de-interleaves the soft estimations or to a channel decoding step S406.

The de-interleaving step S405 may de-interleave the soft estimations code block by code block or may de-interleave the soft estimations by set of code blocks if interleaving is performed on a set of code blocks.

The output of the de-interleaving step S405 if there is provided to the iterative channel decoding step S406.

The channel decoding step S406 is for example a LDPC (Low Density Parity Check) decoder or a CTC (Convolutional Turbo Code) decoder or a BTC (Block Turbo Code) decoder or a polar code decoder.

The output of the channel decoding step S406 is outputted as the decoded symbols and provided to the subtracting step S407. The subtracting step S407 calculates the extrinsic information from the total information provided by the channel decoding step S406.

The subtracting step S407 subtracts the output of the de-interleaving step if there is one to the output of the channel decoding step S406 or subtracts the output of the de-mapping step S404 to the output of the channel decoding step S406.

The output of the subtracting step S407 so-called extrinsic information is provided to the interleaving step S408 if there is, which performs a reverse process as the one performed by the de-interleaving step S405. The output of the interleaving step S407 if there is, is provided to the block equalization step S401, to the Volterra polynomial calculation step S409 and to the non-linear interference generation step S410 and optionally to the de-mapping step S404.

If the interleaving step S408 is not there, the output of the subtracting step S407, so-called extrinsic information, is provided to the block equalization step S401, to the Volterra polynomial calculation step S409, optionally to the de-mapping step S404, and to the non-linear interference generation step S410.

The output of the Volterra polynomial calculation step S409 is provided to the non-linear interference generation S410.

The output of non-linear interference generation step S410 is provided to the subtracting step S403.

A soft estimation x of the transmitted data is obtained from the log-likelihood information provided by the subtracting step S407, this information having passed through the optional interleaving module S408. The estimate interference $I_{n-d}$ is obtained by the non-linear interference generation step S410 from the Volterra series by ignoring the term corresponding to the data to be estimated:

$$I_{n-d} = \sum_{n_1=0}^{M-1} h_{n_1} x_{n-n_1} + \sum_{n_1=0}^{M-1}\sum_{n_1=0}^{M-1}\sum_{n_2=0}^{M-1} h_{n_1 n_2 n_3} x_{n-n_1} x_{n-n_2} \overline{x}_{n-n_3} + \ldots$$

$$+ \sum_{n_1=0}^{M-1}\sum_{n_1=0}^{M-1}\ldots\sum_{n_{k-1}=0}^{M-1} h_{n_1\ldots n_{k-1}} x_{n-n_1} x_{n-n_2}\ldots\overline{x}_{n-n_{k-1}} - h_d x_{n-d}$$

$$d = \frac{M-1}{2},$$

Here, $d$ is the delay associated with the Volterra series, generally $M$ is the memory size of the Volterra series and the subtracted term $h_d x_{n-d}$ corresponds to the information to be estimated.

In order to simplify the analysis, the Volterra polynomial is represented as:

$$y_n = \sum_{i=0}^{N-1} a_i \phi(\underline{x}_n)$$

where $\underline{x}_n$ is a vector containing $x_n$ and its neighbours, $N$ is the number of terms, $\phi_i(.)$ are the Volterra terms (or kernels), $a_i$ are the coefficients.

$$\underline{x}_n = \left(x_{n-f}, x_{n-f+1}, \ldots, x_{n+b}\right)^T$$

with $b+f+1 = M$, the memory of the Volterra series.

Generally $b=f=(M-1)/2$.

The $a_i$ terms correspond to a renaming of the $h_{n_1\ldots n_{k-1}}$, after reordering of these coefficients.

Without any loss in generality, we will assume that the first term is the central one, corresponding to $x_n$ :

$$\phi_0\left(\underline{x}_n\right) = x_n$$

With these notations, the interference is expressed as:

$$I_n = P\left(\underline{x}_n\right) - a_0 x_n = \sum_{i=1}^{N-1} a_i \phi_i\left(\underline{x}_n\right)$$

It must be noted that as the Volterra series is only a model of the global chain, this interference term is only an estimation of the real interference.

Moreover, in the turbo loop represented in Fig. 4, the values $x_n$ are not perfectly known. The subtracting step S407 provides the so-called extrinsic information, which after passing through the (optional) interleaving step S408, acts as a priori information for the block equalization step S401, the non-linear interference generation step S410 and optionally the de-mapping step S404. In practice, this *a priori* information consists in log-likelihood ratio (the LLR). From these LLR, it is straightforward to derive the probabilities associated with each constellation point and each transmitted symbol, and then to derive the mean of each Volterra term $E(\phi_i(\underline{x}_n))$ where E is the probabilistic mean, estimated from the extrinsic information.

Finally, the used interference estimation is obtained as:

$$E\left(I_n\right) = \sum_{i=1}^{N-1} a_i\, E\left(\phi_i\left(\underline{x}_n\right)\right)$$

The Volterra polynomial calculation step S409 determines the Volterra coefficients $a_i$.

The Volterra coefficients $a_i$ are calculated from known sequences $x_n$ and the corresponding linearly equalized symbols $y_n$ provided by the output of the IDFT step S402.

Concerning the known sequences, they can be either fixed sequences sent regularly, for example for synchronization or channel estimation, or sequences that have been decoded correctly by the channel decoding step S406.

The coefficients are calculated so as to minimize the mean of the square error:

$$\min_{a_i} E\left(\left\| y_n - \sum_{i=0}^{N-1} a_i\, \phi_i\left(\underline{x}_n\right)\right\|^2\right)$$

Let us define the vectors $a = (a_0,...,a_{N-1})^T$, $X_n = (\phi_0(\underline{x}_n),...,\phi_{N-1}(\underline{x}_n))^T$, the above mentioned equation can be rewritten as:

$$\min_a E\left(\left| y_n - a^T X_n\right|^2\right)$$

This is a particular case of polynomial regression applied to Volterra series. The solution is provided by:

$$a = R^{-1} z$$

where the autocorrelation matrix $R$ is defined as:

$$R_{ij} = E\left(\phi_i \overline{\phi_j}\right)$$

and the correlation vector $z$ between the observation $y$ and the kernels $\phi_i$ associated to the input $x$ is defined as:

$$z_i = E\left(y \overline{\phi_i}\right)$$

The coefficients may be determined by memorizing a given amount of known sequences $x_n$ and linearly equalized symbols $y_n$, evaluating $R$ and $z$ from these known sequences $x_n$ and linearly equalized symbols $y_n$ and then resolve equation $a = R^{-1}z$.

According to the invention each value $z_i$ is compared to a threshold value, that is for example equal to $3.0\ 10^{-3}$, for an average value of the amplitude of x equal to 1. The optimal value depends on the scenario, for example depends of the robustness of the modulation and coding scheme.

For each value of $z_i$ that is lower than the threshold value, the corresponding coefficient $a_i$ is not calculated.

In the proposed scheme, the linear equalization is performed before the Volterra correction. Therefore, the correction only depends on the power amplifier and the transmit/receive filters, which change very slowly or not at all.

Several solutions exist for the resolution of the linear system $a = R^{-1}z$.

The simplest adaptive algorithm is LMS (Least Mean Square). Let us call $a_n$ the estimation vector $a$ at instant $n$ (the corresponding observation $X_n$ is defined above). Then, the coefficient vector is updated by:

$$a_{n+1} = a_n + \mu X_n e_n = a_n + \mu X_n \left( y_n - a_n^T X_n \right)$$

where $e_n$ is the instantaneous error, and where $\mu$ is the gain constant that regulates the speed and stability of adaptation.

For example, error $e_n$ is averaged on K several successive received samples before applying $a_{n+K} = a_n + \mu X_n \, average(e_n)$.

In this case, the coefficients are updated every K samples, and a larger gain $\mu$ can be used.

The LMS method has the advantage not to rely on knowledge or estimation of $R$ matrix.

When $R$ matrix is known, the LMS/Newton method may be used. As $R$ matrix depends only of used constellation, the receiver may memorize the inverse matrix $R^{-1}$ that corresponds to the used constellation. The coefficient vector is now updated by:

$$a_{n+1} = a_n + \mu R^{-1} X_n e_n = a_n + \mu R^{-1} X_n \left( y_n - a_n^T X_n \right)$$

It has to be noted here that error $e_n$ may be averaged on K several successive received samples as previously disclosed for the LMS algorithm:

$$a_{n+K} = a_n + \mu R^{-1} X_n \, average\left( e_n \right)$$

This LMS/Newton method is known to converge more rapidly than the LMS method and is less complex than the RLS (Recursive Least Square) method.

## Claims

1. A method for demodulating received symbols using a turbo equalization loop for a single carrier system, the method comprises the steps of:

   - performing a discrete Fourier transform on the received symbols,
   - equalizing in the frequency domain the discrete Fourier transform received symbols in order to obtain equalized symbols,
   - executing an inverse discrete Fourier transform on the equalized symbols in order to obtain equalized symbols in the time domain,

   **characterized in that** the method further comprises the steps of:

   - executing a first subtracting step by subtracting, from equalized symbols in the time domain, non-linear interference,
   - de-mapping the output of the first subtracting step,
   - decoding the output of the de-mapping step,
   - executing a second subtracting step by subtracting, from the output of decoding step, the input of the decoding step,

   and the output of second subtracting step is provided to the equalization step, to the non-linear interference generation step, the non-linear interference being obtained by a Volterra series, the coefficients of which are determined from the equalized symbols in the time domain.

2. The method according to claim 1, **characterized in that** the Volterra coefficients determination is further determined from the output of second subtracting step or from fixed known transmitted symbols.

3. The method according to claim 2, **characterized in that** non-linear interference is derived from:

$$E\left(I_n\right) = \sum_{i=1}^{N-1} a_i\, E\left(\phi_i\left(\underline{x}_n\right)\right)$$

where $\underline{x}_n$ is a vector containing $x_n$ and its neighbours, $N$ is the number of terms, $\phi_i(.)$ are the Volterra terms, $a_i$ are the coefficients, $I_n$ is the interference and $E$ is the probabilistic mean, estimated from the extrinsic information provided by the second subtracting step.

4. The method according to claim 3, **characterized in that** the coefficients $a_i$ are determined from $a = R^{-1}z$, where $R$ is an autocorrelation matrix $R$ defined as :

$$R_{ij} = E\left(\phi_i\,\overline{\phi}_j\right)$$

and z is a correlation vector between the linearly equalized symbols $y_n$ and the kernels $\phi_i$ associated to the input $x$ , and where the $z_i$, the components of $z$ are defined as:

$$z_i = E\left(y\,\overline{\phi}_i\right)$$

and wherein for each value of $z_i$ that is lower than a predetermined threshold value, the corresponding coefficient $a_i$ is not calculated, $y_n$ are the realizations at time n of the probabilistic variable y and correspond to the equalized symbols in the time domain.

5. The method according to claim 4, **characterized in that** the coefficients may be determined by memorizing a given amount of known $x_n$ and linearly equalized symbols $y_n$.

6. The method according to claim 4, **characterized in that** the method is executed by a receiver that comprises memory means that memorize one inverse of the autocorrelation matrix for each constellation that may be used for transferring the received symbols.

7. A device for demodulating received symbols using a turbo equalization loop for a single carrier system, the device comprises:

    - means for performing a discrete Fourier transform on the received symbols,
    - means for equalizing in the frequency domain the discrete Fourier transform received symbols in order to obtain equalized symbols,
    - means for executing an inverse discrete Fourier transform on the equalized symbols in order to obtain equalized symbols in the time domain,

**characterized in that** the device further comprises:

    - means for executing a first subtracting step by subtracting, from equalized symbols in the time domain, non-linear interference,
    - means for de-mapping the output of the first subtracting step,
    - means for decoding the output of the de-mapping step,
    - means for executing a second subtracting step by subtracting, from the output of decoding step, the input of the decoding step,

and the output of second subtracting step is provided to the equalization step, to the non-linear interference generation step, the non-linear interference being obtained by a Volterra series, the coefficients of which are determined from the equalized symbols in the time domain.

8. The device according to claim 7, **characterized in that** the Volterra coefficients determination is further determined from the output of second subtracting step or from fixed known transmitted symbols.

9. A computer program comprising program code instructions which cause a programmable device to implement the method according to any one of claims 1 to 6, when the program code instructions are run by the programmable device.

**Patentansprüche**

1. Verfahren zum Demodulieren empfangener Symbole unter Verwendung eines Turbo-Entzerrerkreises für ein Einzelträgersystem, wobei das Verfahren die folgenden Schritte umfasst:

- Durchführen einer diskreten Fouriertransformation an den empfangenen Symbolen,
- Entzerren, im Frequenzbereich, der empfangenen Symbole der diskreten Fouriertransformation, um entzerrte Symbole zu erhalten,
- Ausführen einer inversen diskreten Fouriertransformation an den entzerrten Symbolen, um entzerrte Symbole im Zeitbereich zu erhalten,

**dadurch gekennzeichnet, dass** das Verfahren weiterhin die folgenden Schritte umfasst:

- Ausführen eines ersten Subtraktionsschritts durch Subtrahieren nichtlinearer Interferenz von entzerrten Symbolen im Zeitbereich,
- Rückabbilden der Ausgabe des ersten Subtraktionsschritts,
- Decodieren der Ausgabe des Rückabbildungsschritts,
- Ausführen eines zweiten Subtraktionsschritts durch Subtrahieren der Eingabe des Decodierschritts von der Ausgabe des Decodierschritts,

und die Ausgabe des zweiten Subtraktionsschritts zum Entzerrungsschritt, zum Erzeugungsschritt für eine nichtlineare Interferenz, geliefert wird, wobei die nichtlineare Interferenz durch eine Volterra-Reihe erhalten wird, deren Koeffizienten aus den entzerrten Symbolen im Zeitbereich bestimmt werden.

2. Verfahren nach Anspruch 1, **dadurch gekennzeichnet, dass** die Bestimmung von Volterra-Koeffizienten weiterhin aus der Ausgabe des zweiten Subtraktionsschritts oder aus festen bekannten übertragenen Symbolen bestimmt wird.

3. Verfahren nach Anspruch 2, **dadurch gekennzeichnet, dass** eine nichtlineare Interferenz abgeleitet wird aus:

$$E(I_n) = \sum_{i=1}^{N-1} a_i E\left(\phi_i(\underline{x}_n)\right)$$

wobei $\underline{x}_n$ ein Vektor ist, der $x_n$ und seine Nachbarn enthält, N die Anzahl von Ausdrücken ist, $\phi_i(.)$ die Volterra-Ausdrücke sind, $a_i$ die Koeffizienten sind, $I_n$ die Interferenz ist und $E$ das Wahrscheinlichkeitsmittel ist, das aus der extrinsischen Funktion geschätzt ist, die durch den zweiten Subtraktionsschritt bereitgestellt ist.

4. Verfahren nach Anspruch 3, **dadurch gekennzeichnet, dass** die Koeffizienten $a_i$ aus $a = R^{-1}z$ bestimmt werden, wobei $R$ eine Autokorrelationsmatrix $R$ ist, die definiert ist als:

$$R_{ij} = E\left(\phi_i \overline{\phi_j}\right)$$

und $z$ ein Korrelationsvektor zwischen den linear entzerrten Symbolen $y_n$ und den mit der Eingabe $x$ assoziierten Kerneln $\phi_i$ ist, und wobei $z_i$, die Komponenten von $z$, definiert sind als:

$$z_i = E\left(y\overline{\phi}_i\right)$$

und wobei für jeden Wert von $z_i$, der kleiner als ein vorbestimmter Schellenwert ist, der entsprechende Koeffizient $a_i$ nicht berechnet wird, $y_n$ die Realisierungen zur Zeit $n$ der Wahrscheinlichkeitsvariablen $y$ sind und den entzerrten Symbolen im Zeitbereich entsprechen.

**5.** Verfahren nach Anspruch 4, **dadurch gekennzeichnet, dass** die Koeffizienten durch Merken bzw. Speichern einer gegebenen Menge von bekannten $x_n$ und linear entzerrten Symbolen $y_n$ bestimmt werden können.

**6.** Verfahren nach Anspruch 4, **dadurch gekennzeichnet, dass** das Verfahren durch einen Empfänger ausgeführt wird, der eine Speichereinrichtung umfasst, die eine Inverse der Autokorrelationsmatrix für jede Konstellation speichert, die zum Transferieren der empfangenen Symbole verwendet werden kann.

**7.** Vorrichtung zum Demodulieren empfangener Symbole unter Verwendung eines Turbo-Entzerrerkreises für ein Einzelträgersystem, wobei die Vorrichtung folgendes umfasst:

- Mittel zum Durchführen einer diskreten Fouriertransformation an den empfangenen Symbolen,
- Mittel zum Entzerren, im Frequenzbereich, der empfangenen Symbole der diskreten Fouriertransformation, um entzerrte Symbole zu erhalten,
- Mittel zum Ausführen einer inversen diskreten Fouriertransformation an den entzerrten Symbolen, um entzerrte Symbole im Zeitbereich zu erhalten,

**dadurch gekennzeichnet, dass** die Vorrichtung weiterhin folgendes umfasst:

- Mittel zum Ausführen eines ersten Subtraktionsschritts durch Subtrahieren nichtlinearer Interferenz von entzerrten Symbolen im Zeitbereich,
- Mittel zum Rückabbilden der Ausgabe des ersten Subtraktionsschritts,
- Mittel zum Decodieren der Ausgabe des Rückabbildungsschritts,
- Mittel zum Ausführen eines zweiten Subtraktionsschritts durch Subtrahieren der Eingabe des Decodierschritts von der Ausgabe des Decodierschritts,

und die Ausgabe des zweiten Subtraktionsschritts zum Entzerrungsschritt, zum Erzeugungsschritt für eine nichtlineare Interferenz, geliefert wird, wobei die nichtlineare Interferenz durch eine Volterra-Reihe erhalten wird, deren Koeffizienten aus den entzerrten Symbolen im Zeitbereich bestimmt werden.

**8.** Vorrichtung nach Anspruch 7, **dadurch gekennzeichnet, dass** die Bestimmung von Volterra-Koeffizienten weiterhin aus der Ausgabe des zweiten Subtraktionsschritts oder aus festen bekannten übertragenen Symbolen bestimmt wird.

**9.** Computerprogramm, das Programmcodeanweisungen umfasst, die eine programmierbare Vorrichtung veranlassen, das Verfahren nach einem der Ansprüche 1 bis 6 zu implementieren, wenn die Programmcodeanweisungen durch die programmierbare Vorrichtung laufengelassen werden.

**Revendications**

**1.** Un procédé de démodulation de symboles reçus utilisant une boucle de turbo-égalisation pour un système à porteuse unique, le procédé comportant les étapes de :

- exécution d'une transformée de Fourier discrète sur les symboles reçus,
- égalisation dans le domaine fréquentiel des symboles reçus transformés par la transformée de Fourier discrète pour obtenir des symboles égalisés,
- exécution d'une transformée de Fourier discrète inverse sur les symboles égalisés afin d'obtenir des symboles égalisés dans le domaine temporel,

**caractérisé en ce que** le procédé comporte en outre les étapes de :

- exécution d'une première étape de soustraction en soustrayant, aux symboles égalisés dans le domaine temporel, des interférences non linéaires,
- démappage de la sortie de la première étape de soustraction,
- décodage de la sortie de l'étape de démappage,
- exécution d'une deuxième étape de soustraction en soustrayant, à la sortie de l'étape de décodage, l'entrée de l'étape de décodage,

et la sortie de la deuxième étape de soustraction est fournie à l'étape d'égalisation, à l'étape de génération d'interférence non linéaire, l'interférence non linéaire étant obtenue par une série de Volterra, dont les coefficients sont déterminés à partir des symboles égalisés dans le domaine temporel.

2. Le procédé selon la revendication 1, **caractérisé en ce que** la détermination des coefficients de Volterra est en outre déterminée à partir de la sortie de la deuxième étape de soustraction ou à partir de symboles transmis connus fixes.

3. Le procédé selon la revendication 2, **caractérisé en ce que** l'interférence non linéaire est dérivée de :

$$E\left(I_n\right) = \sum_{i=1}^{N-1} a_i\, E\left(\phi_i\left(\underline{x}_n\right)\right)$$

où $\underline{x}_n$ est un vecteur contenant $x_n$ et ses voisins, $N$ est le nombre de termes, $\phi_i(.)$ sont les termes de Volterra, $a_i$ sont les coefficients, $I_n$ est l'interférence et $E$ est la moyenne probabiliste, estimée à partir des informations extrinsèques fournies par la deuxième étape de soustraction.

4. Le procédé selon la revendication 3, **caractérisé en ce que** les coefficients $a_i$ sont déterminés à partir de $a = R^{-1}z$, où $R$ est une matrice d'autocorrélation $R$ définie comme :

$$R_{ij} = E\left(\phi_i\, \overline{\phi}_j\right)$$

et z est un vecteur de corrélation entre les symboles linéairement égalisés $y_n$ et les noyaux $\phi_i$ associés à l'entrée x, et où $z_i$, les composantes de z sont définies comme :

$$z_i = E\left(y\, \overline{\phi}_i\right)$$

et dans lequel pour chaque valeur de $z_i$ qui est inférieure à une valeur de seuil prédéterminée, le coefficient correspondant $a_i$ n'est pas calculé, $y_n$ sont les réalisations au temps $n$ de la variable probabiliste $y$ et correspondent aux symboles égalisés dans le domaine temporel.

5. Le procédé selon la revendication 4, **caractérisé en ce que** les coefficients peuvent être déterminés en mémorisant une quantité donnée connue $x_n$ et de symboles égalisés linéairement $y_n$.

6. Le procédé selon la revendication 4, **caractérisé en ce que** le procédé est exécuté par un récepteur qui comporte des moyens de mémorisation qui mémorisent une matrice d'autocorrélation inverse pour chaque constellation qui peut être utilisée pour transférer les symboles reçus.

7. Un dispositif de démodulation de symboles reçus utilisant une boucle de turbo-égalisation pour un système à porteuse unique, le dispositif comportant :

- des moyens d'exécution d'une transformée de Fourier discrète sur les symboles reçus,
- des moyens d'égalisation dans le domaine fréquentiel des symboles reçus transformés par la transformée de Fourier discrète pour obtenir des symboles égalisés,
- des moyens d'exécution d'une transformée de Fourier discrète inverse sur les symboles égalisés afin d'obtenir des symboles égalisés dans le domaine temporel,

**caractérisé en ce que** le dispositif comporte en outre :

- des moyens d'exécution d'une première étape de soustraction en soustrayant, aux symboles égalisés dans le domaine temporel, des interférences non linéaires,
- des moyens de démappage de la sortie de la première étape de soustraction,
- des moyens de décodage de la sortie de l'étape de démappage,
- des moyens d'exécution d'une deuxième étape de soustraction en soustrayant, à la sortie de l'étape de décodage, l'entrée de l'étape de décodage,

et la sortie de la deuxième étape de soustraction est fournie à l'étape d'égalisation, à l'étape de génération d'interférence non linéaire, l'interférence non linéaire étant obtenue par une série de Volterra, dont les coefficients sont déterminés à partir des symboles égalisés dans le domaine temporel.

8. Le dispositif selon la revendication 7, **caractérisé en ce que** la détermination des coefficients Volterra est en outre déterminée à partir de la sortie de la deuxième étape de soustraction ou à partir de symboles transmis fixes connus.

9. Un programme informatique comprenant des instructions de code de programme qui provoque un dispositif programmable à mettre en œuvre le procédé selon l'une quelconque des revendications 1 à 6, lorsque les instructions de code de programme sont exécutées par le dispositif programmable.

Src

Source

Rec

## Fig. 1

Rec

200 Processor

Ant

203 RAM

Wireless I/F 205

201

202 ROM

## Fig. 2

Fig. 3

S400 — DFT

S401 — Equalization

S402 — IDFT

To S409

S403 — Subtract non linear interference

S404 — De-mapping

S405 — De-interleaving

To S407

S406 — Channel decoding

S407 — Subtract de-interleaved

S408 — Interleaving

To S401, S409, S410 and S404

S409 — Volterra polynomial calculation

S410 — non linear interference generation

Fig. 4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3151434 A1

- US 2013336377 A1

**Non-patent literature cited in the description**

- **S. BENEDETTO ; E. BIGLIERI ; R. DAFFARA.** Modeling and Performance Evaluation of Nonlinear Satellite Links - A Volterra Series Approach. *IEEE AES-15,* July 1979

- **B. F. BEIDAS ; R. I. SESHADRI ; M. EROZ ; L. LEE.** Faster-than-Nyquist Signaling and Optimized Signal Constellation for High Spectral Efficiency Communications in nonlinear Satellite Systems. *IEEE MILCOM,* 2014